(19) Europäisches Patentamt
European Patent Office
Office européen des brevets

(11) EP 4 333 086 A1

(12) EUROPEAN PATENT APPLICATION
published in accordance with Art. 153(4) EPC

(43) Date of publication:
**06.03.2024 Bulletin 2024/10**

(21) Application number: **22795620.8**

(22) Date of filing: **18.04.2022**

(51) International Patent Classification (IPC):
***H01L 41/193*** (2006.01) ***H01L 41/113*** (2006.01)
***H01L 41/257*** (2013.01) ***H02N 2/18*** (2006.01)

(52) Cooperative Patent Classification (CPC):
**H02N 2/18; H10N 30/045; H10N 30/30; H10N 30/857**

(86) International application number:
**PCT/JP2022/018032**

(87) International publication number:
**WO 2022/230707 (03.11.2022 Gazette 2022/44)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **28.04.2021 JP 2021076711**

(71) Applicant: **Mitsui Chemicals, Inc.**
**Tokyo 104-0028 (JP)**

(72) Inventors:
- **OKABE, Jun**
  **Chuo-ku, Tokyo 104-0028 (JP)**
- **SUNAGA, Tadahiro**
  **Chuo-ku, Tokyo 104-0028 (JP)**
- **TOKITO, Shizuo**
  **Yonezawa-shi, Yamagata 992-8510 (JP)**

(74) Representative: **Hoffmann Eitle**
**Patent- und Rechtsanwälte PartmbB**
**Arabellastraße 30**
**81925 München (DE)**

# (54) POLYMER PIEZOELECTRIC FILM ELEMENT, POWER STORAGE DEVICE USING SAME, AND LOAD DETECTION DEVICE

(57) Provided is a polymer piezoelectric film element which generates electricity at a high sensitivity upon vibrations across a broad frequency band, including those caused by the motion of humans or animals or faint contact stress, and those caused by automobiles and so on, , which can be made into a thin film and at a high yield, and which can be used as a stably driving power supply device, a tactile sensor, or a vital sensor. The present invention pertains to: a polymer piezoelectric film element characterized in that an electrode sheet is formed on both surfaces of a polymer piezoelectric film, and by having a structure which has bumps and dips or a wave-shaped structure which has peaks and valleys in an axis perpendicular to said surfaces; and a power storage device, a sensor, or a vital sensor.

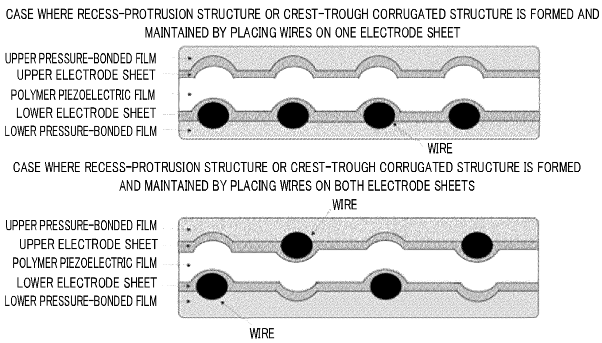


FIG. 2

EP 4 333 086 A1

## Description

Technical Field

The present invention relates to a polymer piezoelectric film element in which electrode sheets are formed on both surfaces of a polymer piezoelectric film and which has a structure with bumps and dips or a wave-shaped structure with peaks and valleys in an axis perpendicular to the surfaces, a power storage device including the polymer piezoelectric film element, and a load detection device.

Background Art

According to the General Energy Statistics published by Agency for Natural Resources and Energy in Japan, Japan increased supply of its domestic primary energy since the World War II, due to Japan's economic growth from 1950s to 1970s and subsequent IT innovation until the early 2000s, and has leveled off at approximately 20,000 petajoules per year since the 2011 off the Pacific coast of Tohoku Earthquake until 2019. The proportion of primary energy supplied as electricity was 41% in 1990, but exceeded 46% in 2018 due to further advanced electrification in Japanese society in recent years.

Japan's Energy White Paper 2019 shows the breakdown of power generation for electricity supply in 2019: proportions of liquid natural gas (hereinafter referred to as LNG), coal-fired power, oil-fired power, hydraulic power, nuclear energy, and renewable energy were 40%, 32%, 9%, 8%, 3%, and 8%, respectively. One of characteristics since 2011 described above is increased dependence on LNG and coal-fired power because of the shutdown of some nuclear power plants. However, as targeted by the Paris Agreement in 2016, reduction of greenhouse gas mainly composed of carbon dioxide has been urgent imperative so as to limit global warming. In particular, it is a worldwide common request to break dependence on coal-fired power generation and convert to renewable energy. Note that, the Act on the Promotion of the Use of Non-fossil Energy Sources and Effective Use of Fossil Energy Source Materials by Energy Suppliers in Japan defines renewable energy as "sunlight, wind power, and other non-fossil energy sources, which are specified by Cabinet Order as being recognized as perpetually usable energy sources", and specifies sunlight, wind power, geothermal power, solar thermal power, biomass, and the like.

The United States which amount of electricity supply is the second largest in the world depend on LNG, coal-fired, and nuclear energy almost equally, and the ratio of renewable energy is 10%. China which amount of electricity supply is the largest in the world depends mostly on coal-fired and the ratio of renewable energy is just 9%. Although each European country have different proportions of dependence, it is worth mentioning the fact that the proportion of dependence on renewable energy is 34% in Germany. These major countries and Japan are different from a point of view that renewable energy in the major countries is mainly wind power, whereas Japan's main renewable energy is photovoltaics.

While the world faces to challenge to reduce the dependence on power generation based on fossil fuels such as LNG, coal, and oil, and convert to renewable energy, innovation through self-driving transportation like automobiles, high-speed communication of large amounts of data associated with further use of computers and mobile terminals, accelerated digital transformation, and Internet of Things (hereinafter referred to as IoT) has been more active, and more electronic devices have been used for such activities. The electricity required to drive those electronic devices has been increasing for the time being. Such future society is said to be a data-driven society in which diverse and an enormous amount of data are accumulated in cyberspace and utilized for services that are provided to people. Given this background, more electronic devices have been used in everyday life, but the electricity that drives the electronic devices should not depend just on the aforementioned fossil fuel-based power generation in the future.

Further, the electronic devices should not receive electricity only by transmission from large power plants such as hydraulic power, nuclear power, and wind power. That is, devices capable of converting a conventionally overlooked energy source into electricity which are independent from aforementioned electricity transmission are desirable. Those devices serve as power sources for local production and consumption to drive electronic equipment and sensors installed everywhere including mountain areas, oceans, and polar areas where humans are difficult to approach. Primary batteries are independent power sources, but have a finite usable time and are difficult to consider as appropriate power sources in the future society where stable drive and no leakage of critical information are required for self-driving, high-speed communication of data, and IoT described above. Secondary batteries are not appropriate power sources, either, since they require charging after consumption of electricity.

When a conventionally overlooked energy source is obtained from a nearby, common, and semi-permanently existing physical phenomenon and the physical phenomenon is converted into a voltage and is used as electricity, it is possible to semi-permanently drive electronic equipment and sensors as long as they do not suffer mechanical break. Thus, there is no need to replace or charge the batteries and it is possible to continue to collect critical information without leakage in the above-described new society. Further, it is also effective for capital investment within limited funding since

it is not necessary to provide a power transmission network for supplying electricity generated by power plants. In addition, the fact that a nearby physical phenomenon can be converted into a voltage is valuable since it can be handled as a sensor for detection of a signal to prevent an accident or a disaster in advance.

Examples of nearby physical phenomena that can be converted into electricity include light, stresses, heat, and magnetic fields. In case of light conversion into electricity, the photovoltaic effect attained by semiconductors is used as in solar cells. For converting a stress or heat to electricity, on the other hand, a substance called a ferroelectric is utilized. The phenomenon of converting a stress into electricity is called the piezoelectric effect and the phenomenon of converting heat into electricity is called the pyroelectric effect, which are generated by a ferroelectric. To obtain the pyroelectric effect, however, temperature changes are required but it is difficult to generate electricity somewhere under a stable temperature. Then, the phenomenon of converting a magnetic field into electricity is called the magnetoelectric effect and research on materials having both ferroelectricity and ferromagnetism has progressed in recent years, but it is insufficient for practical use since the magnetic field on the earth is very small. Because of these reasons, expansion of the utilization of the piezoelectric effect is important in terms of obtaining electricity from a conventionally overlooked energy source. Stresses such as vibrations are generated in various places, such as those caused by motions of humans or animals, transportations such as automobiles and trains, building construction works, and factory equipment in the manufacturing industries, and therefore can be converted into electricity from such places. Further, a sensor that detects a stress is also possible. Hereinafter, the generation of an electric charge by utilizing the piezoelectric effect and the utilization of the electric charge as electricity or for a sensor will be referred to as "power generation".

Power generation technology utilizing vibrations has been developed for a long time. Patent Literature (hereinafter referred to as "PTL") 1 discloses that a vibration power generation apparatus including: a support stage; a plurality of elastic bodies for supporting the support stage; and a plurality of power generation elements provided in the support stage stably generates power by an inputted vibration. In the apparatus, the support stage and the plurality of elastic bodies form a first resonator, the plurality of power generation elements forms a second resonator, and power generation can be stably performed by configuring the difference of natural frequency between the first resonator and the second resonator to be equal to or less than ± 15%. In the power generation element disclosed in PTL 1, however, a leaf spring, of which one end freely swings, and a piezoelectric element are together with, and a piezoelectric layer forming the piezoelectric element is an inorganic ferroelectric having a hard and brittle nature, which is selected from lead zirconate titanate (hereinafter referred to as PZT), aluminum nitride, lithium tantalate, lithium niobate, and the like. Accordingly, the range of applicable stresses and the range of displacements to be induced cannot be said to be wide.

Further, in this vibration power generation apparatus, since a plurality of springs, a plurality of piezoelectric elements, and the plurality of power generation elements are complicatedly configured, the thickness of the vibration power generation apparatus is at a centimeter level and thus the vibration power generation apparatus cannot be located easily due to its bulk when considering its use in an electronic equipment or a sensor used in daily lives. In addition, the vibration power generation apparatus has a low productivity and a problem on its durability against vibrations.

Further, PTL 2 discloses a vibration power generation element which includes a cantilever including a piezoelectric element and in which a weight is provided at a position separated from the cantilever and, when an external force is installed thereon, the weight moves toward the cantilever and collides to the cantilever to perform power generation. In the same manner as in PTL 1, the cantilever has a structure in which only one end thereof is fixed to a chassis (hereinafter this structure will be referred to as a cantilever structure), and a hard and brittle perovskite-type oxide such as PZT is used for a piezoelectric film. Accordingly, the range of applicable stresses and the range of displacements to be induced cannot be said to be wide. Further, the vibration power generation element fixed to a pedestal made of silicone or stainless steel is required to be disposed in a vacuum, which encumbers the production cost. In addition, although the initial performance of the power generation element can be guaranteed, the cantilever and the piezoelectric film may break due to an external force.

In the cantilever structure of PTLs 1 and 2, the piezoelectric element vibrates only in a specific resonance frequency, and thus, the cantilever structure is subject to restrictions of vibration conditions. For this reason, in order to be applicable to vibrations in a broad frequency band, PTL 3 introduces a vibration power generation device having a double-end supported beam structure in which both ends are fixed. In order to configure the device to have a double-end supported beam structure, a plurality of piezoelectric bodies is placed on a metal elastic plate including a slit, and a plurality of the metal elastic plates is connected by a coupling member. The vibration power generation device is a power generation apparatus in which the metallic elastic plate is displaced with a vibration and the displacement is converted by the piezoelectric body into a voltage, and is utilized as an in-vehicle application system inside and outside an automobile. The power generation device of this invention also utilizes a nonlinear spring for converting a vibration into electric energy.

While PTLs 1 to 3 use an inorganic ferroelectric as a piezoelectric body, research and development of polymer materials exhibiting the piezoelectric effect has been advanced since the discovery of the ferroelectric properties of polyvinylidene fluoride by Kawai et al. in 1969 (Non-Patent Literature (hereinafter referred to as "NPL") 1). The motivation for the development of polymer materials lies in the attraction in mechanical properties that polymer materials are capable

of balance between peculiar hardness and softness, which can be expressed only by polymer materials, and having toughness, and the polymer materials can be made into a thin film. It is not limited to the piezoelectric effect, but attempts to replace characteristics of inorganic materials with polymer materials and express similar performances and create new values have been made for many years in diverse fields, and therefore this is always a critical point of view in materials development. For example, in the automobile field where the ratio of steel materials was previously high, reduction in weight has been realized due to an increased use ratio of polymer materials such as polypropylene, which results in the creation of values as capability of traveling a long distance with a small amount of energy. In the healthcare field where glass was previously used for eyeglass lenses, glass was replaced by a polymer material called thiourethane that allows thinner and lighter eyeglass lenses with superior impact resistance, which enables a lot of people to use eyeglasses easily without feeling weight. Further, in the recent electronics field, research and development of pastes and inks for printing which includes a pulverized hard metal and a flexible polymer material such as polyurethane, and an organic solvent are intensified, because current electric wiring produced by a surface treatment using photoresist coating, etching, plating, or the like has been demanded to be flexible and free designable in recent years, and a new market has been formed thereby. As described above, polymer materials have the potential for innovation in every field, and it can be understood that the research and development of polymer materials aimed at the piezoelectric effect was started in line with such expectations.

An inorganic ferroelectric such as PZT actually expresses an excellent piezoelectric effect by creating a single crystal or polycrystalline structure, but has disadvantage of being susceptible to conditional constraints in terms of usability due to its brittle nature. On the other hand, a polymer material exhibiting the piezoelectric effect (hereinafter referred to as a polymer piezoelectric material) has a crystalline structure and also has an amorphous structure to some extent. Since the amorphous structure does not normally exhibit the piezoelectric effect, a polymer piezoelectric material is often inferior in the piezoelectric effect, but is excellent in flexibility and toughness in comparison with an inorganic ferroelectric, and thus has an advantage of being hardly broken. This advantage is expressed by a crystal structure and an amorphous structure existing in a mixed manner (NPL 2).

As an example of inventions using a polymer piezoelectric material, a flexible piezoelectric sheet described in PTL 4, in which a polymer piezoelectric layer of polyamino acid, polysaccharide, polylactic acid, polyvinylidene fluoride, or the like is held between two conductive cloth layers obtained by impregnating a base fiber such as silk with a conductive polymer material such as poly(3,4-ethylenedioxythiophene) and poly(styrenesulfonic acid). This invention uses a cloth containing a conductive polymer material as an electrode and has a structure with flexibility by combining the cloth with a polymer piezoelectric material, but a safety problem remains when the conductive polymer material comes into contact with a human body.

Further, another example of the use of a polymer piezoelectric material is a laminated power generation body and its power generation apparatus described in PTL 5, which obtain electricity from various ocean energy of tidal currents, tide, waves, or the like. The laminated power generation body is obtained by forming piezoelectric films and electrodes on both surfaces of a base made of a flexible elastic material. Silicone rubber, natural rubber, or synthetic rubber is used for the flexible elastic material, and polyvinylidene fluoride or polyvinylidene cyanide is used for the piezoelectric film. The laminated power generation body is, however, only applicable to calm oceans and cannot be said to be capable of overcoming the problems of renewable energy.

## Citation List

### Patent Literature

PTL 1
WO 2020/230509
PTL 2
WO 2020/235208
PTL 3
Japanese Patent Application Laid-Open No. 2020-061938
PTL 4
Japanese Patent Application Laid-Open No. 2020-119995
PTL 5
Japanese Patent Application Laid-Open No. 2014-111911

Non-Patent Literature

NPL 1
H. Kawai; Jpn. J. Appl. Phys., 8, 975 (1969)
NPL 2
Field Responsive Polymers, Chapter 6, pp. 88-103
NPL 3
Kenji Uchino, Ferroelectric Devices, Morikita Publishing Co., Ltd., p.142

Summary of Invention

Technical Problem

In the power generation element indicated in PTL 1, however, the leaf spring and the piezoelectric element are integrally formed and the piezoelectric body layer forming the piezoelectric element is made of an inorganic ferroelectric selected from PZT, aluminum nitride, lithium tantalate, lithium niobate, and the like, but the piezoelectric body layer has a hard and brittle nature, and thus, the range of applicable stresses and the range of displacements to be induced are not wide.
In addition, in the vibration power generation element of PTL 2, a perovskite-type oxide is used for the piezoelectric film, and thus, the range of applicable stresses and the range of displacements to be induced are not wide in the same manner as described above. A metal such as aluminum and zirconia is often used for the cantilever on which the piezoelectric film is placed and which receives a vibration, but the cantilever cannot be said to have resistance to displacement, that is, toughness. Further, since the weight is provided at the position separated from the cantilever, the vibration power generation element becomes thicker because of the separated distance cannot be easily used due to a change in design in view of its installation in an existing facility.
Further, although the vibration power generation device of PTL 3 utilizes the double-end supported beam structure and is devised to be provided with a fixed lubricating layer at a stopper and Teflon electroless nickel such that the piezoelectric body exceeded its elastic limit, the vibration power generation device is structurally complicated. In addition, a material selected from aluminum nitride, scandium-containing aluminum nitride, magnesium- and niobium-containing aluminum nitride, potassium sodium niobate, and the like, which are similar to the materials described in PTLs 1 and 2, is used for the piezoelectric body, and is subjected to mechanical destruction in the same manner as described above.
Unlike the piezoelectric layers made of an inorganic ferroelectric in PTLs 1 to 3, the piezoelectric sheet described in PTL 4 uses a polymer piezoelectric material of polyamino acid, polysaccharide, polylactic acid, or polyvinylidene fluoride with a characteristic of flexibility and is further devised to incorporate a flexible electrode substrate material, and thus, the piezoelectric sheet can be adapted to various places and shapes including a human body. Nevertheless, the use of the polymer piezoelectric material faces to a problem that it should be handled an output voltage lower than that of an inorganic ferroelectric. A voltage to be outputted in response to a stress is represented by equation 1 described later, where piezoelectric d constant as a proportional constant corresponds to the inherent value of d33 when a piezoelectric material is horizontally placed and a stress is given thereto from a perpendicular axis. For example, while d33 of PZT that is an inorganic ferroelectric is 289 pC/N, d33 of PVDF that is a polymer ferroelectric is only 35 pC/N (NPL 3).
That is, a polymer ferroelectric has a significantly lower output voltage than an inorganic ferroelectric, and therefore it can be used as a sensor for limited applications, but it is clearly insufficient for utilization capable of detecting vibrations of diverse frequencies and strengths or storing power to use for electricity to drive other electronic equipment.
[1]

$$V = d \cdot t \cdot \sigma / \varepsilon \qquad \text{... (Equation 1)}$$

where V: output voltage, d: piezoelectric d constant of piezoelectric layer, t: thickness of piezoelectric layer, $\sigma$: stress, and $\varepsilon$: dielectric constant.
Further, unlike PVDF which creates a crystal structure by uniaxial stretching and becomes a polymer ferroelectric by electric field application, polylactic acid is a polymer piezoelectric material which exhibits the piezoelectric effect only by creating a crystal structure by uniaxial stretching, but is not a ferroelectric. Polylactic acid has d33 = 0 due to its material properties and does not allow an output voltage due to a stress from a perpendicular axis when placing its film horizontally. In this case, an output voltage is generated by use of the stretched film by pulling it toward a direction of

45° with respect to the stretching direction. In addition, a polymer ferroelectric such as PVDF has an extremely low output voltage in comparison with an inorganic ferroelectric, and a polymer piezoelectric material such as polylactic acid which generates a weak output voltage only by pulling toward a limited direction is practically difficult to use, because of a point of a low output voltage.

That is, an output voltage generated by some polymer piezoelectric materials is required to be increased to a level at which they can be replaced by inorganic ferroelectrics, and if this requirement is realized, minimizing the effect of extraneous noise is possible for a sensor. Further, in the case of the use for a power storage device, large power generation is possible from a small stress, thereby making it possible to utilize the energy, which is discarded hitherto as electricity. That is, development of a technique to increase a voltage to be outputted helps popularize devices using a polymer piezoelectric material.

Note that, the power generation body in PTL 5 is capable of addressing ocean energy of tidal currents, tide, waves, or the like with various sizes by using a film of a polymer piezoelectric material of polyvinylidene fluoride, polyvinylidene cyanide or the like, and is suitable for utilization of a vibration of a fluid such as seawater, but when a power generation apparatus in which the power generation bodies having a rod shape are arranged is located on land a vibration from a motion of a human or an animal, a transportation such as an automobile and a train, construction-related works, and a thing such as a factory facility in the manufacturing industry, the power generation apparatus is supposed to be easily broken at the time of receiving a stress, and is therefore difficult to apply. That is, a design of a device which does not break even when receiving various vibrations on land is required.

As described above, power generation using a vibration as a nearby physical phenomenon, for example, a vibration from a motion of a human or an animal, a transportation such as an automobile and a train, construction-related works, a factory facility in the manufacturing industry, or the like with the piezoelectric effect is clean power generation for local production and consumption that does not use electricity produced by power plants, and has high cost advantages in that the electricity supplied semi-permanently from the clean power generation enables the realization of a data-driven society by driving electronic equipment and sensors continuously without battery replacement, charging, and new power transmission network construction. Further, the piezoelectric effect can not only ensure electricity, but also allow a vibration detecting sensor that transmits reception of a stress, and makes it possible to collect information such as the presence of humans, animals, and automobiles, amounts of movement, noise in the construction and manufacturing industries, and symptoms of abnormal phenomena.

The present invention is to provide a polymer piezoelectric film element which generates electricity at a high degree of sensitivity in response to vibrations across a broad frequency band, including vibrations of a comparatively low frequency no higher than 10Hz such as, for example, a faint contact stress or those caused by motions of humans or animals, and also including vibrations of a high frequency equal to or higher than 10Hz such as those caused by automobiles, trains and other transport vehicles, building construction work, and factory equipment in the manufacturing industry. The polymer piezoelectric film element can be utilized as: a sensor which stably detects vibrations and loads without easy break; a vital or tactile sensor that measures a bioelectric signal such as a pulse wave, a heart rate, and a respiratory wave; and a power supply device that can be used to drive other electronic equipment.

## Solution to Problem

The present invention relates to a polymer piezoelectric film element in which electrode sheets are formed on both surfaces of a polymer piezoelectric film and which has a structure with bumps and dips or a wave-shaped structure with peaks and valleys in an axis perpendicular to the surfaces. The polymer piezoelectric film element is installed a stress from outside and generates electricity by its piezoelectric effect to use as a sensor detecting vibrations and loads, a vital sensor measuring bioelectric signal such as a pulse wave, a heart rate, a respiratory wave, a tactile sensor, and a power storage device to drive other electronic equipment.

## Advantageous Effects of Invention

According to the present invention, the use of a polymer piezoelectric film having characteristics such as a thin film property, flexibility, and toughness makes it possible to generate electricity from a walk of a human or a terrestrial animal or from traveling of an automobile by simply burying the polymer piezoelectric film element in the ground such as a floor, or to perform power generation from a stress such as a vibration in a broad band emitted from a train, a heavy machine or a manufacturing apparatus to which the polymer piezoelectric film is attached. Thus, it is possible to provide: a sensor that detects a vibration; a sensor that detects a load; a vital or tactile sensor that measures a bioelectric signal such as a pulse wave, a heart rate, and a respiratory wave; a power storage device to drive other electronic equipment.

Brief Description of Drawings

FIG. 1 is a diagram provided for describing a polymer piezoelectric film element in which electrode sheets are formed on both surfaces of a polymer piezoelectric film and which has a structure with bumps and dips or a wave-shaped structure with peaks and valleys in an axis perpendicular to the surfaces;

FIG. 2 is a diagram provided for describing a cross-sectional structure in which a structure with bumps and dips or a wave-shaped structure with peaks and valleys is formed and kept in an axis perpendicular to a surface(s) of a polymer piezoelectric film by placing wires on an electrode sheet(s);

FIG. 3 is a diagram provided for describing a cross-sectional structure in which a structure with bumps and dips or a wave-shaped structure with peaks and valleys is formed and kept in an axis perpendicular to a surface(s) of a polymer piezoelectric film by placing wires between an electrode sheet(s) and the polymer piezoelectric film;

FIG. 4 is a diagram provided for describing a cross-sectional structure in which a structure with bumps and dips or a wave-shaped structure with peaks and valleys is formed and kept by placing a molded body/molded bodies having a structure with bumps and dips or a wave-shaped structure with peaks and valleys;

FIG. 5 is a diagram provided for describing a power storage device circuit formed of a polymer piezoelectric film element, a full-wave rectification circuit formed of four diode elements, a capacitor, and a DC/DC converter;

FIG. 6 is a diagram provided for describing measurement of a pulse wave as an example of a bioelectric signal by using the polymer piezoelectric film element;

FIG. 7 is a diagram provided for describing a circuit that outputs a constant voltage in response to an applied load by using the polymer piezoelectric film element; and

FIG. 8 is a diagram provided for describing how constant voltages are outputted when static loads are applied in the order of 2.0 kg, 4.5 kg, 7.5 kg, and 11 kg for 10 seconds in each case to the polymer piezoelectric film element by using the circuit in FIG. 7.

Description of Embodiment

Hereinafter, an embodiment of the present invention will be described.

Hereinafter, the configuration of a polymer piezoelectric film element according to the present embodiment will be described with reference to FIG. 1. The polymer piezoelectric film element according to the present embodiment is made by forming an upper electrode sheet and a lower electrode sheet on both surfaces of a polymer piezoelectric film and then configuring a structure with bumps and dips or a wave-shaped structure with peaks and valleys in an axis perpendicular to the surfaces. Note that, the upper electrode sheet and the lower electrode sheet do not mean the top and the bottom, and are merely distinction for the description. This structure with bumps and dips or wave-shaped structure with peaks and valleys includes a bump or a peak as a rising portion and a dip or a valley as a dent portion with respect to the perpendicular axis to the polymer piezoelectric film on which the upper electrode sheet and the lower electrode sheet are formed, but the bump or the peak and the dip or the valley also do not mean the top and the bottom, and are merely distinction for the description.

Here, the structure with bumps and dips or the wave-shaped structure with peaks and valleys according to the present embodiment refers to bumps and peaks having a height and a width or to dips and valleys having a depth and a width. The height is defined as the gap of a portion of the outermost surface of the polymer piezoelectric film element, where the portion is flat (hereinafter referred to as a flat portion), to the peak of a rising portion or as the depth from the flat portion to the lowest point of a dent portion. The shape of the outermost surface of the polymer piezoelectric film element is measured by a method such as a stylus surface shape measurement and a laser microscope, focusing on one bump or dip or one peak or valley. Then, the width is defined as the length of a rising portion from a flat portion to a flat portion with one bump or dip or one peak or valley therebetween or as the length of a dent portion from a flat portion to a flat portion with one bump or dip or one peak or valley therebetween.

In the present invention, for example, this height is preferably equal to or greater than 80 $\mu$m, and more preferably equal to or greater than 200 $\mu$m. In a case where the height difference is less than 80 $\mu$m, the sensitivity or the output voltage is low, and the effect of the structure with bumps and dips or the wave-shaped structure with peaks and valleys may be difficult to be exhibited. Further, the width of a bump/dip or a peak/valley is preferably equal to or greater than 0.1 mm, and more preferably equal to or greater than 1 mm. In a case where the width is less than 0.1 mm, the effect of the structure with bumps and dips or the wave-shaped structure with peaks and valleys may be difficult to be exhibited. Further, the upper limit of the height or the width is determined by the size, design, and use method of the element, and is therefore not particularly limited.

Further, the method of forming this structure with bumps and dips or wave-shaped structure with peaks and valleys is not particularly limited as long as the structure can be formed and the polymer piezoelectric film can be held

so as not to return to the original horizontal condition in FIG. 1 over time. For example, there are a method in which wires are placed on the lower electrode sheet or/and the upper electrode sheet and are held by pressure-bonding and fixing with a pressure-bonded film(s) as illustrated in FIG. 2, a method in which wires are placed between the electrode sheet(s) and the polymer piezoelectric film and pressure-bonding and fixing are performed with a pressure-bonded film(s) as illustrated in FIG. 3, a method in which a molded body/bodies having a structure with bumps and dips or a wave-shaped structure with peaks and valleys obtained by embossed molding or the like is/are placed on the electrode sheet(s) and pressure-bonding and fixing are performed with a pressure-bonded film(s) as illustrated in FIG. 4, a method in which bead-like granular objects are dispersed on the electrode sheet(s) or/and on the polymer piezoelectric film and pressure-bonding and fixing are performed, and the like. FIGS. 2 and 3 illustrate a case where four wires are placed on one of the electrode sheets or two wires are placed on each of the electrode sheets, but it is configured in the present embodiment that a wire(s) can be placed on one or both of the electrode sheets, and further the number of wires is not limited and one or more wires are placed. Further, two or more wires may be placed so as to be parallel with each other or intersect each other within a plane. Note that, not only wires, but wire-like or thread-like fibers may also be used. Examples of the method of forming and holding the structure with bumps and dips or the wave-shaped structure with peaks and valleys include a method of applying a pressure-bonded film(s) while manually pressurizing, a method of using a laminator, a method of using a vacuum-packaging apparatus, and the like, but the method of forming and holding the structure with bumps and dips or the wave-shaped structure with peaks and valleys is not particularly limited. Note that, in a case where a wire(s) is/are placed, the wire(s) may be placed not only in a structure in which one or more wires are placed linearly, but may be placed after being molded into an annularly closed shape such as a circular shape, a triangle shape, a square shape, a pentagon shape, a hexagon shape, or the like, or such a net-like structure with annular holes may be placed.

In addition, the wire is preferably made of a material having a circular shape and a cross-sectional diameter of 0.10 mm or more and 1.0 mm or less and having a Young's modulus of 1 GPa or more. A cross-sectional diameter less than 0.10 mm does not make it possible to obtain a structure with bumps and dips or a wave-shaped structure with peaks and valleys having a height and a width that are sufficient for generating electricity from the polymer piezoelectric film element. It has been found that the rigidity of the polymer piezoelectric film element to be described later becomes remarkable when the cross-sectional diameter exceeds 1.0 mm, which is a problem in terms of decrease of electromotive force and practicability. Note that, the shape of the cross section of the wire is not particularly limited, but is preferably a pentagon shape, a hexagon shape, or an oval shape in addition to a circular shape since in a case where the wire has an acute angle of a triangle shape, a square shape or the like, the electrode sheet(s) and/or the polymer piezoelectric film may be cracked thereby during the pressure-bonding and fixing described above. Further, although the material of the wire is not particularly limited, the wire contains, in its core portion, preferably a metal such as iron, copper, aluminum, magnesium, titanium, zinc, and chrome, an alloy thereof, a plastic, or a ceramic, all of which has a Young's modulus of 1 GPa or more since it is necessary to configure the structure with bumps and dips or the wave-shaped structure with peaks and valleys by transferring the shape of the wire to the polymer piezoelectric film, the lower electrode sheet, and the upper electrode sheet. A case in which the material of the wire has a Young's modulus less than 1 GPa causes the stress of pressure-bonding and fixing to be used for deformation of the wire itself and does not lead to formation of the structure with bumps and dips or the wave-shaped structure with peaks and valleys having a height and a width that are sufficient for generating electricity.

Note that, the inner side and/or outer side of the wire may be provided with a resin, a paint, a coating, or the like to protect the metal from corrosion and scratching. Further, the shape may be that of a granular object instead of that of a wire. This granular object has an outer diameter of 0.10 mm or more and 1.0 mm and less and is formed of preferably a material having a Young's modulus equal to or greater than 1 GPa.

The polymer piezoelectric film according to the present embodiment is prepared as form of a film state. Any polymer compound can be used for the polymer piezoelectric film as long as the polymer piezoelectric film outputs a voltage by receiving a stress. Examples thereof include polymer compounds such as polyvinylidene fluoride (hereinafter referred to as PVDF), a vinylidene fluoride-trifluoroethylene copolymer (hereinafter referred to as P(VDF-TrFE)), poly-L-lactic acid (hereinafter referred to as PLLA), poly-D-lactic acid (hereinafter referred to as PDLA), poly-$\gamma$-methyl-L-glutamate, poly-$\gamma$-benzyl-L-glutamate, polypropylene oxide, nylon 11, polyvinyl chloride, and polyurea, but the polymer compound may be preferably selected from PVDF, P(VDF-TrFE) and PLLA from a viewpoint of availability. Note that, PVDF has the piezoelectric effect by forming a $\beta$-type crystalline structure when PVDF is made into a film by uniaxial stretching, bringing both surfaces of the PVDF film into contact with electrodes to apply electric field application, and performing polarization processing, which results in a ferroelectric. For P(VDF-TrFE), on the other hand, a film that has a $\beta$-type crystal structure by uniaxial stretching in the same manner as with PVDF may be subjected to polarization processing by electric field application, but P(VDF-TrFE) may obtain the piezoelectric effect by coating its varnish, which is obtained by dissolving powder of P(VDF-TrFE) in a polar organic solvent such as methyl ethyl ketone, N-methyl-2-pyrrolidone, dimethylacetamide, N,N-dimethylformamide, triethyl phosphate, and cyclopentanone, on a suitable base material, heating at a temperature equal to or higher than a temperature at which the polarization of P(VDF-TrFE)

disappears, that is, the Curie temperature and simultaneously heating and removing the organic solvent, cooling under a temperature lower than a crystallization temperature to form a β-type crystal structure, and performing polarization processing by electric field application, which results in a ferroelectric. In a case where P(VDF-TrFE) is made into a film by a method of coating a varnish, a polymer piezoelectric film of P(VDF-TrFE) is used by being peeled off from the base material coated with the varnish.

Piezoelectric d constant d33 of a PVDF film prepared by the process described above, where d33 refers to piezoelectric d constant in a case where a stress is given from the perpendicular axis, is 35 pC/N. In the case of a P(VDF-TrFE) film, piezoelectric d constant depends on the molar ratio of trifluoroethylene (hereinafter referred to as TrFE) which is a copolymerizable monomer. For example, d33 is 27 pC/N in a case where the molar ratio is 20%, d33 is 22 pC/N in a case where the molar ratio is 30%, and d33 is 20 pC/N in a case where the molar ratio is 45%. Unlike PVDF and P(VDF-TrFE), PLLA and PDLA exhibit the piezoelectric effect by the molecular chain orientation and crystallization by uniaxial stretching, and therefore do not need to become ferroelectrics by polarization by electric field application. In the case of a PLLAfilm, the piezoelectric effect of d33 is not exhibited with a stress given from the perpendicular, but the piezoelectric effect is exhibited by pulling the film towards a horizontal axis at an angle of 45° with respect to the uniaxial stretching direction. Piezoelectric d constant d14 that is piezoelectric d constant in the above case is 6.5 pC/N. As described above, the expression of the piezoelectric effect requires understanding of characteristics of each polymer compound and appropriate processing. Note that, the thickness of the polymer piezoelectric film is preferably 5 μm or more and 100 μm or less, and more preferably 40 μm or more and 100 μm or less. Because of this thickness range, a structure with bumps and dips or a wave-shaped structure with peaks and valleys having a height and a width that are sufficient for generating electricity is formed.

The lower electrode sheet and the upper electrode sheet according to the present embodiment are not particularly limited, but preferably have a Young's modulus of 1 MPa or more and a thickness of 100 nm or more and 100 μm or less. Examples of materials having a Young's modulus of 1 MPa or more include metals are aluminum, titanium, chromium, manganese, iron, cobalt, nickel, copper, zinc, zirconium, silver, indium, tin, tungsten, platinum, and gold, oxides and alloys of these metals, conductive carbon compounds such as graphene and carbon nanotubes, and organic polymer conductive compounds such as polythiophene, polyethylenedioxythiophene/polystyrenesulfonic acid, polyaniline, polypyrrole, polyacetylene, polyparaphenylene, and polyparaphenylenevinylene. The method of the formation thereof on the polymer piezoelectric film is not particularly limited, either, and a method of bonding via a conductive adhesive layer, a vacuum vapor deposition method, a sputtering method, a method of forming the electrode sheets by printing using a paste or ink of such a conductive material, such as soft blanket gravure offset printing, inkjet printing, dispenser, screen printing, gravure offset printing, flexographic printing, letterpress reverse printing, spin coating, spray coating, blade coating, dip coating, cast coating, cast coating, roll coating, bar coating, and die coating, and subsequent annealing of the paste or ink, or other methods can be used.

During the process of forming the lower electrode sheet and the upper electrode sheet, however, attention should be paid to the heat resistance of the polymer piezoelectric film. When PVDF and P(VDF-TrFE) are heated at a temperature equal to or higher than the Curie temperature, the polarization disappears and PVDF and P(VDF-TrFE) become no longer ferroelectrics, and thus, the piezoelectric effect is lost. Accordingly, PVDF and P(VDF-TrFE) are managed such that the electrode sheets are formed at a temperature equal to or lower than the Curie temperature. The Curie temperature is approximately 170°C for PVDF. For P(VDF-TrFE), the Curie temperature varies depending on the molar ratio of TrFE, and thus, the electrode sheets are formed at a temperature equal to or lower than the Curie temperature of the copolymer with the molar ratio to be used. For example, the Curie temperature is 130 to 140°C in a case where the molar ratio of TrFE is 20%, the Curie temperature is 95 to 105°C in a case where the molar ratio is 30%, and the Curie temperature is 57 to 62°C in a case where the molar ratio is 45%. Curie temperatures of PVDF and P(VDF-TrFE) to be used should be understood, and they are handled at a temperature lower than the Curie temperatures. For PLLA, the piezoelectric effect starts decreasing at 66°C of the glass transition temperature or higher, and thus, the electrode formation is preferably performed at a temperature equal to or lower than 65°C. Further, it is not only about the temperature of heating, but the time thereof are also preferably shortened as much as possible.

Note that, in a case where the Young's modulus of the lower electrode sheet and the upper electrode sheet is less than 1 MPa, there is a problem that the stress when the shape of the wire is transferred to the polymer piezoelectric film to configure the structure with bumps and dips or the wave-shaped structure with peaks and valleys is relaxed at the electrode sheets and a structure with bumps and dips or a wave-shaped structure with peaks and valleys having a height and a width that are sufficient for generating electricity cannot be formed. In addition, when the thickness of the electrode sheet is equal to or less than 100 nm, a tear may occur in the vicinity of the wire at the time of the transfer, and the conductivity may be lost. When the thickness is equal to or greater than 100 μm, it is too hard for the electrode sheet to transfer the wire shape cannot to the polymer piezoelectric film, and it is difficult to give a stress for configuring a structure with bumps and dips or a wave-shaped structure with peaks and valleys having a height difference and a width that are sufficient for generating electricity. Note that, the lower electrode sheet and the upper electrode sheet may be formed of the same material by the same formation method or may be formed of different materials by different

formation methods.

The polymer piezoelectric film element prepared by the method described above outputs a voltage in response to a stress applied from the perpendicular axis described in FIG. 1. In the present invention, understanding of influences of differences among structures with bumps and dips or wave-shaped structures with peaks and valleys, which are formed by various wire arrangement designs, on output voltages was advanced. The relationship between the stress and the output voltage is represented by following equation 2.

[2]

$$V = a \cdot \sigma \qquad \text{... (Equation 2)}$$

where V: output voltage, a: output proportional constant, and $\sigma$: stress.

In the present invention, stresses were applied to the polymer piezoelectric film element from the perpendicular axis by varying wires of various cross-sectional diameters and various materials, the number of wires, the distance between wires and the wire arrangement, and outputted voltages were measured. By the measurements, a in equation 2 is calculated, which is defined as the output proportional constant in the present invention. When the output proportional constant specific to the structure with bumps and dips or the wave-shaped structure with peaks and valleys is large, the output voltage becomes high, and thus, the performance as the polymer piezoelectric film element is high. Details of the experiments will be described in examples and comparative examples to be described later. The polymer piezoelectric film element using PVDF has a high output proportional constant and a high output voltage due to the structure with bumps and dips or the wave-shaped structure with peaks and valleys of PVDF by placing a wire(s) or a molded body/bodies as illustrated in FIGS. 2, 3, and 4. The above output proportional constant is so high that is not expressed by PVDF in a horizontal film state described in FIG. 1. Further, PLLA which doesn't generate electricity with respect to a stress from the perpendicular axis in the horizontal film state described in FIG. 1 exhibits a large output proportional constant due to the structure with bumps and dips or the wave-shaped structure with peaks and valleys by placing a wire(s) or a molded body/bodies, and a high output voltage is obtained. Accordingly, the structure with bumps and dips or the wave-shaped structure with peaks and valleys by using a wire(s) can amplify the electromotive force, piezoelectric sensitivity, and the like of the polymer piezoelectric film.

That is, it is not limited to PVDF and PLLA, but a stress applied from the perpendicular axis is concentrated on bumps or peaks and/or on dips or valleys and the amount of electric charge generation is increased in the three axis directions by forming the structure with bumps and dips or the wave-shaped structure with peaks and valleys for the polymer piezoelectric film. The present invention revealed that the increased electric charge is generated because a stress is dispersed in the three directions including the horizontal axis in FIG. 1, and thus, the electromotive force and the piezoelectric sensitivity significantly are improved and the piezoelectric effect is amplified. Note that, the electrode sheets and a wire(s) or a molded body/bodies may be not only placed on one polymer piezoelectric film, but an amplified piezoelectric effect can also be obtained by holding two or more polymer piezoelectric films laminated with double-sided pressure-sensitive adhesive sheets or the like and placed a wire(s) or a molded body/bodies on the electrode sheets.

Further, the power storage device stores electricity, which is generated by applying a stress to the polymer piezoelectric film element of the present embodiment, in a capacitor. In more detail, it has been found that utilization of a polymer piezoelectric film which has conventionally been low in electromotive force and for which it is difficult to store electricity makes it possible to store electricity as an electric charge, which is outputted by applying a stress to the polymer piezoelectric film element with an increased electromotive force in the present invention from the perpendicular axis, in an electronic component such as a capacitor and a supercapacitor, such as an electric double layer capacitor. Since the voltage outputted by the polymer piezoelectric film element is a sinusoidal voltage having both positive and negative polarities, the voltage of the negative polarity is inverted to a positive polarity, is rectified to a positive polarity voltage, and is collected as electricity. Examples of the rectification method include half-wave rectification using one diode element and full-wave rectification using four diode elements, but full-wave rectification is preferably used in terms of efficiency. In the circuit illustrated in FIG. 5, the voltage after the rectification is collected into the capacitor or the like. Further, the voltage stored in the capacitor can be boosted as a DC voltage by connection to a DC/DC converter and can serve as electricity for driving other electronic equipment.

Further, it has been found that the polymer piezoelectric film element of the present embodiment is capable of detecting a pulse wave by bringing the element, which is reduced to a size of an electrode sheet of 15 mm $\times$ 15 mm, into light contact with a wrist and a neck part of a human with a soft touch, for example. As illustrated in FIG. 6, it has been found that a pulse wave detected by the polymer piezoelectric film element of the present embodiment has a waveform having the same shape and frequency as a waveform of a pulse wave acquired by attaching a commercially available photoelectric plethysmogram wave meter on a fingertip of a hand of a human. The polymer piezoelectric film element of the present embodiment can be utilized as a small-sized, lightweight, and low-cost pulse wave detecting element.

Further, the load detection device outputs a constant voltage from an operational amplifier by application of a load to the polymer piezoelectric film element of the present embodiment. It has been found that when a load is applied to the polymer piezoelectric film element from the perpendicular axis and the polymer piezoelectric film element is connected to an electronic circuit that outputs a constant voltage in response to a load value, a voltage value proportional to the load value can be outputted, resulting in a load detection device. The electronic circuit is not particularly limited, but can be configured, for example, as illustrated in FIG. 7, a method in which a voltage outputted by the polymer piezoelectric film element is once collected into a capacitor and the voltage of the capacitor is detected by a voltage follower using an operational amplifier.

Examples

Hereinafter, the present invention will be specifically described with examples, but the present invention is not limited thereto.

[Example 1]

Conductive adhesive layers of copper foil electrode sheets, DAITAC (registered trademark) E20CU (manufactured by DIC Corporation), in which a copper foil and a conductive adhesive layer were laminated, with a size of 82.5 mm × 82.5 mm and a Young's modulus of 110 GPa were bonded to both surfaces of an 82.5 mm × 82.5 mm polymer piezoelectric film of polyvinylidene fluoride, KF Piezo film (registered trademark) (manufactured by KUREHA Corporation), with a thickness of 80 μm such that the conductive adhesive layers came into contact with the polymer piezoelectric film. One 82.5 mm-long wire made of copper with a cross-sectional diameter of 0.5 mm and a Young's modulus of 110 GPa was placed on one of the electrode sheets such that the wire was parallel to an 82.5 mm side of the copper foil electrode sheet, and the edges thereof were fixed by a tape. The resulting intermediate product was pressure-bonded and fixed perpendicularly with pressure-bonded films by desktop roll laminator H355A3 (manufactured by Acco Brands Japan K.K.) to prepare a polymer piezoelectric film element having a structure with bumps and dips or a wave-shaped structure with peaks and valleys in an axis perpendicular to the surfaces. The surface profile of the pressure-bonded films was measured by stylus profiler DektakXT (manufactured by Bruker Corporation), with the result that the height was 200 μm and the width was 4.0 mm. When this polymer piezoelectric film element was placed on a horizontal vibrator table and stresses in a range of 13 to 34 Pa were applied from the perpendicular axis with a pressurizer, voltages of 14 to 29 mV were outputted. As a result, the output proportional constant was an average of 0.93 mV/Pa. In comparison with an element prepared from KF Piezo film (registered trademark) in Comparative Example 1 to be described later in which the output proportional constant was an average of 0.036 mV/Pa, the output voltage with the structure with bumps and dips or the wave-shaped structure with peaks and valleys in the present example increased by an average of 26 times.

[Example 2]

In the same manner as in Example 1, copper foil electrode sheets were bonded to both surfaces of the polymer piezoelectric film. One 82.5 mm-long wire made of copper with a cross-sectional diameter of 0.5 mm and a Young's modulus of 110 GPa was placed on each of the copper foil electrode sheets such that the wire was parallel to a 82.5 mm side of one of the copper foil electrode sheets and the distance between the two wires was 5 mm, and the edges thereof were fixed by a tape. The resulting intermediate product was pressure-bonded and fixed perpendicularly with pressure-bonded films by desktop roll laminator H355A3 (manufactured by Acco Brands Japan K.K.) to prepare a polymer piezoelectric film element having a structure with bumps and dips or a wave-shaped structure with peaks and valleys in an axis perpendicular to the surfaces. The surface profile of the pressure-bonded films was measured in the same manner as in Example 1, with the result that the height was 200 μm and the width was 4.0 mm. When this polymer piezoelectric film element was placed on a horizontal vibrator table and stresses in a range of 13 to 34 Pa were applied from the perpendicular axis with a pressurizer, voltages of 84 to 138 mV were outputted. As a result, the output proportional constant was an average of 5.3 mV/Pa. Since the output proportional constant was an average of 0.036 mV/Pa in the element prepared from KF Piezo film (registered trademark) in Comparative Example 1 to be described later, the output voltage with the structure with bumps and dips or the wave-shaped structure with peaks and valleys in the present example increased by an average of 147 times.

[Example 3]

A polymer piezoelectric film element having a structure with bumps and dips or a wave-shaped structure with peaks and valleys was prepared by changing the polymer piezoelectric film in Example 1 to a 82.5 mm × 82.5 mm polymer piezoelectric film of poly-L-lactic acid, μFLEX (registered trademark) (manufactured by Mitsui Chemicals, Inc.),

with a thickness of 50 μm. The surface profile of the pressure-bonded films was measured in the same manner as in Example 1, with the result that the height was 290 μm and the width was 4.0 mm. When this polymer piezoelectric film element was placed on a horizontal vibrator table and stresses in a range of 13 to 34 Pa were applied from the perpendicular axis with a pressurizer, voltages of 3.1 to 14 mV were outputted. As a result, the output proportional constant was an average of 0.33 mV/Pa. The output proportional constant was 0 mV/Pa in μFLEX (registered trademark) in Comparative Example 2 to be described later. Accordingly, an output with respect to a normal stress in the polymer piezoelectric film element of poly-L-lactic acid was observed for the first time.

[Example 4]

A polymer piezoelectric film element having a structure with bumps and dips or a wave-shaped structure with peaks and valleys was prepared by changing the polymer piezoelectric film in Example 2 to a 82.5 mm × 82.5 mm polymer piezoelectric film of poly-L-lactic acid, μFLEX (registered trademark) (manufactured by Mitsui Chemicals, Inc.), with a thickness of 50 μm. The surface profile of the pressure-bonded films was measured in the same manner as in Example 1, with the result that the height was 290 μm and the width was 4.0 mm. When this polymer piezoelectric film element was placed on a horizontal vibrator table and stresses in a range of 13 to 34 Pa were applied from the perpendicular axis with a pressurizer, voltages of 4.7 to 13 mV were outputted. As a result, the output proportional constant was an average of 0.37 mV/Pa.

[Example 5]

A polymer piezoelectric film element in which the wires described in Example 4 were changed to wires made of copper with a cross-sectional diameter of 0.26 mm and a Young's modulus of 110 GPa was prepared. The surface profile of the pressure-bonded films was measured in the same manner as in Example 1, with the result that the height was 136 μm and the width was 3.5 mm. When this polymer piezoelectric film element was placed on a horizontal vibrator table and stresses in a range of 13 to 34 Pa were applied from the perpendicular axis with a pressurizer, voltages of 4.4 to 16 mV were outputted. As a result, the output proportional constant was an average of 0.41 mV/Pa.

[Example 6]

A polymer piezoelectric film element in which the wires described in Example 4 were changed to wires made of copper with a cross-sectional diameter of 1.0 mm and a Young's modulus of 110 GPa was prepared. The surface profile of the pressure-bonded films was measured in the same manner as in Example 1, with the result that the height was 446 μm and the width was 4.5 mm. When this polymer piezoelectric film element was placed on a horizontal vibrator table and stresses in a range of 13 to 34 Pa were applied from the perpendicular axis with a pressurizer, voltages of 3.1 to 20 mV were outputted. As a result, the output proportional constant was an average of 0.36 mV/Pa.

[Example 7]

Conductive adhesive layers of copper foil electrode sheets, DAITAC (registered trademark) E20CU (manufactured by DIC Corporation), in which a copper foil and a conductive adhesive layer were laminated, with a size of 82.5 mm × 82.5 mm and a Young's modulus of 110 GPa were bonded to both surfaces of the polymer piezoelectric film of poly-L-lactic acid, μFLEX (registered trademark) (manufactured by Mitsui Chemicals, Inc.) in Example 3 such that the conductive adhesive layers came into contact with the polymer piezoelectric film. One wire made of copper with a cross-sectional diameter of 0.5 mm was molded into a circular, annular shape and placed on one of the electrode sheets such that the wire had an inner diameter of 15 mm. The resulting intermediate product was pressure-bonded and fixed perpendicularly with pressure-bonded films by desktop roll laminator H355A3 (manufactured by Acco Brands Japan K.K.) to prepare a polymer piezoelectric film element having a structure with bumps and dips or a wave-shaped structure with peaks and valleys in an axis perpendicular to the surfaces. The surface profile of the pressure-bonded films was measured in the same manner as in Example 3, with the result that the height was 290 μm and the width was 4.0 mm. When this polymer piezoelectric film element was placed on a horizontal vibrator table and stresses in a range of 13 to 34 Pa were applied from the perpendicular axis with a pressurizer, voltages of 2.7 to 12 mV were outputted. As a result, the output proportional constant was an average of 0.24 mV/Pa.

[Comparative Example 1]

Conductive adhesive layers of copper foil electrode sheets, DAITAC (registered trademark) E20CU (manufactured by DIC Corporation), in which a copper foil and a conductive adhesive layer were laminated, with a size of 82.5

mm × 82.5 mm and a Young's modulus of 110 GPa were bonded to both surfaces of a 82.5 mm × 82.5 mm polymer piezoelectric film of polyvinylidene fluoride, KF Piezo film (registered trademark) (manufactured by KUREHA Corporation), with a thickness of 80 μm such that the conductive adhesive layers came into contact with the polymer piezoelectric film. The resulting intermediate product was pressure-bonded and fixed perpendicularly with pressure-bonded films by desktop roll laminator H355A3 (manufactured by Acco Brands Japan K.K.). When this element was placed on a horizontal vibrator table and stresses in a range of 13 to 34 Pa were applied from the perpendicular axis with a pressurizer in the same manner as in Example 1, voltages of 0.50 to 1.2 mV were outputted. As a result, the output proportional constant was an average of 0.036 mV/Pa.

[Comparative Example 2]

A 82.5 mm × 82.5 mm polymer piezoelectric film of poly-L-lactic acid, μFLEX (registered trademark) (manufactured by Mitsui Chemicals, Inc.), with a thickness of 50 μm was used and, in the same manner as in Comparative Example 1, conductive adhesive layers were bonded to the polymer piezoelectric film and the resulting intermediate product was pressure-bonded and fixed perpendicularly with pressure-bonded films by desktop roll laminator H355A3 (manufactured by Acco Brands Japan K.K.). When this element was placed on a horizontal vibrator table and stresses in a range of 13 to 34 Pa were applied from the perpendicular axis with a pressurizer in the same manner as in Example 1, no voltage was generated. The output proportional constant was 0 mV/Pa.

[Example 8]

A conductive adhesive layer of a copper foil electrode sheet, DAITAC (registered trademark) E20CU (manufactured by DIC Corporation), in which a copper foil and a conductive adhesive layer were laminated, with a size of 82.5 mm × 82.5 mm and a Young's modulus of 110 GPa was bonded to one surface of a 82.5 mm × 82.5 mm polymer piezoelectric film of polyvinylidene fluoride, KF Piezo film (registered trademark) (manufactured by KUREHA Corporation), with a thickness of 80 μm such that the conductive adhesive layer came into contact with the polymer piezoelectric film. Two of this intermediate product were prepared. In one of them, a conductive non-woven fabric double-sided adhesive tape, 9720S (manufactured by 3M Japan Limited), having the same size as the electrode was bonded to a surface opposite to an electrode surface of KF Piezo film. Further, a surface opposite to an electrode surface of remaining KF Piezo film with one-sided electrode was bonded to the surface of the conductive non-woven fabric double-sided adhesive tape. One 82.5 mm-long wire of copper with a cross-sectional diameter of 0.5 mm and a Young's modulus of 110 GPa was placed on each surface of the copper foil electrode sheet in which the KF Piezo films were laminated via the conductive tape such that the wires were parallel to a side of the copper foil electrode sheet and the distance between the two wires was 5 mm and the two wires were parallel to each other, and the edges of the wires were fixed by a tape. The resulting intermediate product was pressure-bonded and fixed perpendicularly with pressure-bonded films by desktop roll laminator H355A3 (manufactured by Acco Brands Japan K.K.) to prepare a polymer piezoelectric film element having a structure with bumps and dips or a wave-shaped structure with peaks and valleys in an axis perpendicular to the surfaces. The surface profile of the pressure-bonded films was measured in the same manner as in Example 1, with the result that the height was 240 μm and the width was 3.5 mm. When this polymer piezoelectric film element was placed on a horizontal vibrator table and stresses in a range of 13 to 34 Pa were applied from the perpendicular axis with a pressurizer, voltages of 12 to 42 mV were outputted. As a result, the output proportional constant was an average of 0.93 mV/Pa.

[Comparative Example 3]

In the same manner as in Example 8, an element in which KF Piezo films were laminated via a conductive tape was prepared. In the same manner, the element was pressure-bonded and fixed perpendicularly with pressure-bonded films by desktop roll laminator H355A3 (manufactured by Acco Brands Japan K.K.). When stresses in a range of 13 to 34 Pa were applied from the perpendicular axis in the same manner as in Example 8, voltages of 0.8 to 3.8 mV were outputted. As a result, the output proportional constant was an average of 0.10 mV/Pa.

[Example 9]

Conductive adhesive layers of copper foil electrode sheets, DAITAC (registered trademark) E20CU (manufactured by DIC Corporation), in which a copper foil and a conductive adhesive layer were laminated, with a size of 38 mm × 38 mm and a Young's modulus of 110 GPa were bonded to both surfaces of a 38 mm × 38 mm polymer piezoelectric film of polyvinylidene fluoride, KF Piezo film (registered trademark) (manufactured by KUREHA Corporation), with a thickness of 80 μm such that the conductive adhesive layers came into contact with the polymer piezoelectric film. One

38 mm-long wire made of copper with a cross-sectional diameter of 0.5 mm and a Young's modulus of 110 GPa was placed on each surface of the copper foil electrode sheets such that the wires were parallel to a 38 mm side of the copper foil electrode sheet and the two wires orthogonally intersect each other within the same plane, and the edges thereof were fixed by a tape. The resulting intermediate product was pressure-bonded and fixed perpendicularly with pressure-bonded films by desktop roll laminator H355A3 (manufactured by Acco Brands Japan K.K.) to prepare a polymer piezoelectric film element having a structure with bumps and dips or a wave-shaped structure with peaks and valleys in an axis perpendicular to the surfaces. When this polymer piezoelectric film element was placed on a horizontal vibrator table and stresses in a range of 19 to 90 Pa were applied from the perpendicular axis with a pressurizer, voltages of 26 to 161 mV were outputted. As a result, the output proportional constant was an average of 1.5 mV/Pa. In comparison with an element prepared from KF Piezo film (registered trademark) in Comparative Example 4 to be described later in which the output proportional constant was an average of 0.036 mV/Pa, the output voltage in the present example increased by an average of 42 times.

[Example 10]

One 38 mm-long wire made of copper with a cross-sectional diameter of 0.5 mm and a Young's modulus of 110 GPa was placed on each surface of the polymer piezoelectric film as in Example 9 such that the two wires orthogonally intersect each other within the plane, and the edges thereof were fixed by a tape. Further, conductive adhesive layers of copper foil electrode sheets, DAITAC (registered trademark) E20CU (manufactured by DIC Corporation), in which a copper foil and a conductive adhesive layer were laminated, with a size of 38 mm × 38 mm and a Young's modulus of 110 GPa were bonded to both surfaces of the polymer piezoelectric film such that the conductive adhesive layers came into contact with the polymer piezoelectric film and covered the wires. The resulting intermediate product was pressure-bonded and fixed perpendicularly with pressure-bonded films by desktop roll laminator H355A3 (manufactured by Acco Brands Japan K.K.) to prepare a polymer piezoelectric film element having a structure with bumps and dips or a wave-shaped structure with peaks and valleys in an axis perpendicular to the surfaces. When this polymer piezoelectric film element was placed on a horizontal vibrator table and stresses in a range of 19 to 90 Pa were applied from the perpendicular axis with a pressurizer, voltages of 75 to 748 mV were outputted. As a result, the output proportional constant was an average of 5.3 mV/Pa. Since the output proportional constant was an average of 0.036 mV/Pa in KF Piezo film (registered trademark), which was horizontal, as in Comparative Example 4 to be described later, the output voltage increased by an average of 147 times due to the structure with bumps and dips or the wave-shaped structure with peaks and valleys in the present example.

[Example 11]

A polymer piezoelectric film element having a structure with bumps and dips or a wave-shaped structure with peaks and valleys in an axis perpendicular to the surfaces was prepared in the same manner as in Example 7 except that, instead of the copper foil electrode sheets with the polymer piezoelectric film of poly-L-lactic acid, μFLEX (registered trademark) (manufactured by Mitsui Chemicals, Inc.) in Example 7, a water/alcohol solution of polyethylene dioxythiophene/polystyrene sulfonic acid (manufactured by Heraeus K.K.) was coated and the water/alcohol were evaporated by heating to form both electrodes. The surface profile of the pressure-bonded films was measured in the same manner as in Example 7, with the result that the height was 260 μm and the width was 4.5 mm. When this polymer piezoelectric film element was placed on a horizontal vibrator table and stresses in a range of 13 to 34 Pa were applied from the perpendicular axis with a pressurizer, voltages of 8.4 to 21 mV were outputted. As a result, the output proportional constant was an average of 0.65 mV/Pa.

[Example 12]

In the same manner as in Example 1, copper foil electrode sheets were bonded to both surfaces of a polymer piezoelectric film. In one of the electrode sheets, a PET molded body which has a width of 2 mm, a length of 80 mm, and a height of 0.4 mm and in which lines having a bump were formed in a lattice shape at 3 mm intervals was placed such that the bump surface came into contact with the electrode sheet as illustrated in FIG. 4, and the resulting intermediate product was pressure-bonded and fixed perpendicularly with pressure-bonded films by desktop roll laminator H355A3 (manufactured by Acco Brands Japan K.K.) to prepare a polymer piezoelectric film element having a structure with bumps and dips or a wave-shaped structure with peaks and valleys in an axis perpendicular to the surfaces. The surface profile of the pressure-bonded films was measured in the same manner as in Example 1, with the result that the height was 84 μm and the width was 4.0 mm. When this polymer piezoelectric film element was placed on a horizontal vibrator table and stresses in a range of 13 to 34 Pa were applied from a perpendicular axis to the PET molded body with a pressurizer, voltages of 25 to 29 mV were outputted. As a result, the output proportional constant was an average of

1.2 mV/Pa. Since the output proportional constant was an average of 0.036 mV/Pa in KF Piezo film (registered trademark), which was horizontal, as in Comparative Example 1 described above, the output voltage with the structure with bumps and dips or the wave-shaped structure with peaks and valleys in the present example increased by an average of 33 times.

[Example 13]

The two electrode sheets of the polymer piezoelectric film element in Example 2 were connected to a full-wave rectification circuit formed of four diode elements illustrated in FIG. 5, and were connected to a Zener diode for the purpose of protecting the rectification circuit and to a capacitor of 10 μF that stores the voltage outputted by the polymer piezoelectric film element. When the polymer piezoelectric film element was placed on a horizontal table and the voltage of the capacitor was measured with an oscilloscope while pressurization was continuously performed by hands from the perpendicular axis, a voltage of 4.0 V was stored.

[Example 14]

Seven wires, where the wires were as those in Example 2, were placed on each copper foil electrode sheet and a polymer piezoelectric film element was prepared by the same method as in Example 2. This polymer piezoelectric film element was connected to the same circuit as in Example 13, and a capacitor of 10 μF was connected to DC/DC converter LTC3108 (manufactured by Analog Devices, Inc.) illustrated in FIG. 5. When the polymer piezoelectric film element was placed on a horizontal table and the voltage of the capacitor was measured with an oscilloscope while pressurization was continuously performed by hands from the perpendicular axis, a voltage of 4.0 V was stored in the capacitor, and then a boosted DC voltage of 2.4 V from an output terminal of the LTC3108 was outputted.

[Example 15]

Twelve wires, where the wires were as those in Example 4, were placed on each of the copper foil electrode sheets, and a polymer piezoelectric film element was prepared by the same method as in Example 4. When this polymer piezoelectric film element was connected to the same circuit as in Example 13 and the voltage of the capacitor was measured with an oscilloscope while pressurization was continuously performed by hands from a perpendicular axis to the polymer piezoelectric film element, a voltage of 0.4 V was stored.

[Comparative Example 4]

When the size of the electrode sheets in Comparative Example 1 was changed to a size of 38 mm × 38 mm and stresses in a range of 19 to 90 Pa were applied from the perpendicular axis, voltages of 0.7 to 3.3 mV were outputted. As a result, the output proportional constant was an average of 0.036 mV/Pa.

[Example 16]

The length of the wire was configured to be 15 mm, the size of the electrode sheets was configured to be 15 mm × 15 mm, and a polymer piezoelectric film element was prepared by the same method as in Example 2. The two electrode sheets were connected to a coaxial cable by using a conductive adhesive, and the coaxial cable was connected to an oscilloscope. While a photoelectric plethysmogram wave meter was attached to a fingertip of a human and the pulse wave was optically measured as a reference, the polymer piezoelectric film element was brought into light contact with pulse generation portions in a wrist and a neck part of the human, a clear pulse wave was detected as illustrated in FIG. 6. The waveforms and frequencies of the photoelectric plethysmogram wave of the reference and the pulse wave using the polymer piezoelectric film element were consistent.

[Comparative Example 5]

The size of the electrode sheets were configured to be 15 mm × 15 mm and an element prepared by the same method as in Comparative Example 1 was brought into contact with pulse generation portions in a wrist and a neck part of a human by the same method as in Example 16, no pulse wave was detected.

[Example 17]

As illustrated in FIG. 7, the polymer piezoelectric film element in Example 15 was connected to a voltage follower formed of a resistor of 10 kQ, a capacitor of 10 nF, and an operational amplifier, and output voltages of the voltage

follower were measured when static loads were applied in the order of 2.0 kg, 4.5 kg, 7.5 kg, and 11 kg to the polymer piezoelectric film element. Further, output voltages of the voltage follower were measured when unloading in the order of 11 kg, 7.5 kg, 4.5 kg, and 2.0 kg. As a result, an output voltage of 150 mV for 2.0 kg, an output voltage of 280 mV for 4.5 kg, an output voltage of 400 mV for 7.5 kg, and an output voltage of 550 mV for 11 kg were generated as illustrated in FIG. 8, constant voltages corresponding to the loads were outputted. The output voltages in a case where the load to be applied was increased and the output voltages in a case where the unloading was performed were the same.

[Comparative Example 6]

The element in Comparative Example 2 was connected to the same circuit as in Example 17 and static loads were applied in the order of 2.0 kg, 4.5 kg, 7.5 kg, and 11 kg to the element, but no output voltage was generated from the voltage follower.

This application claims priority of Japanese Patent Application No. 2021-076711, filed on April 28, 2021, the contents of which including the specification, claims, and drawings are incorporated herein by reference.

Industrial Applicability

The polymer piezoelectric film element of the present invention which has a structure with bumps and dips or a wave-shaped structure with peaks and valleys in an axis perpendicular to the surfaces of a polymer piezoelectric film makes it possible to realize a seat-like light, flexible power generation device and a sensor that detects a stress or a minute electromotive force, and makes it possible to provide a device that can be easily installed without affecting the physical shape of a portion where a stress is generated. The polymer piezoelectric film element can be used for sensors for welfare medical applications; sensors for wearable device applications and transistor applications for smartphones, tablet terminals, computers, displays or the like; applications of sensors or control parts for medical and nursing beds, crime prevention, childcare, autonomous driving of automobiles, pet robots, drones or the like; and applications of electronic parts for organic EL, liquid crystal displays, lighting, automobiles, robots, electronic glasses, music players or the like.

## Claims

1. A polymer piezoelectric film element in which electrode sheets are formed on both surfaces of a polymer piezoelectric film, wherein the polymer piezoelectric film has a structure that is a structure with bumps and dips or a wave-shaped structure with peaks and valleys in an axis perpendicular to the surfaces.

2. The polymer piezoelectric film element according to claims 1, wherein the polymer piezoelectric film element has the structure by placing a wire on one or both of the electrode sheets and performing pressure-bonding and fixing with a pressure-bonded film.

3. The polymer piezoelectric film element according to claim 1 or 2, wherein the polymer piezoelectric film is a uniaxially stretched film of polyvinylidene fluoride having a constitutional unit represented by following general formula 1, the uniaxially stretched film having been subjected to polarization.

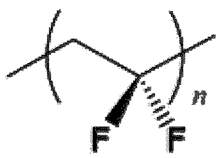

… (General Formula 1)

4. The polymer piezoelectric film element according to claim 1 or 2, wherein the polymer piezoelectric film is a uniaxially stretched film of a copolymer of vinylidene fluoride and trifluoroethylene, the uniaxially stretched film having been subjected to polarization, the copolymer having a constitutional unit represented by following general formula 2.

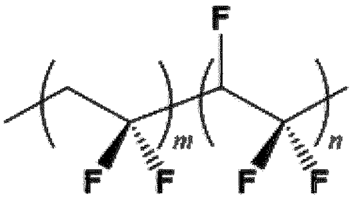

… (General Formula 2)

5. The polymer piezoelectric film element according to claim 1 or 2, wherein the polymer piezoelectric film is a uniaxially stretched film of poly-L-lactic acid having a constitutional unit represented by following general formula 3.

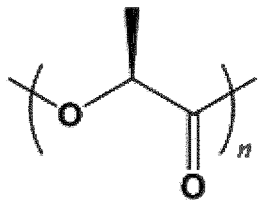

… (General Formula 3)

6. The polymer piezoelectric film element according to any one of claims 1 to 5, wherein at least one of the electrode sheets has a Young's modulus of 1 MPa or more and a thickness of 100 nm or more and 100 μm or less.

7. The polymer piezoelectric film element according to any one of claims 1 to 6, comprising a wire placed on one or both of the electrode sheets, one or more of the wires being placed in a straight line.

8. The polymer piezoelectric film element according to any one of claims 1 to 6, comprising a wire placed on one or both of the electrode sheets, one or more of the wires being placed in an annular shape.

9. The polymer piezoelectric film element according to any one of claims 1 to 8, comprising a wire placed on one or both of the electrode sheets, one or more of the wires being formed of a material having a cross-sectional diameter of 0.10 mm or more and 1.0 mm or less and a Young's modulus of 1 GPa or more.

10. A power storage device, wherein the power storage device stores electricity generated by application of a stress to the polymer piezoelectric film element according to claim 1 in a capacitor.

11. A load detection device, wherein the load detection device outputs a constant voltage from an operational amplifier by application of a load to the polymer piezoelectric film element according to claim 1.

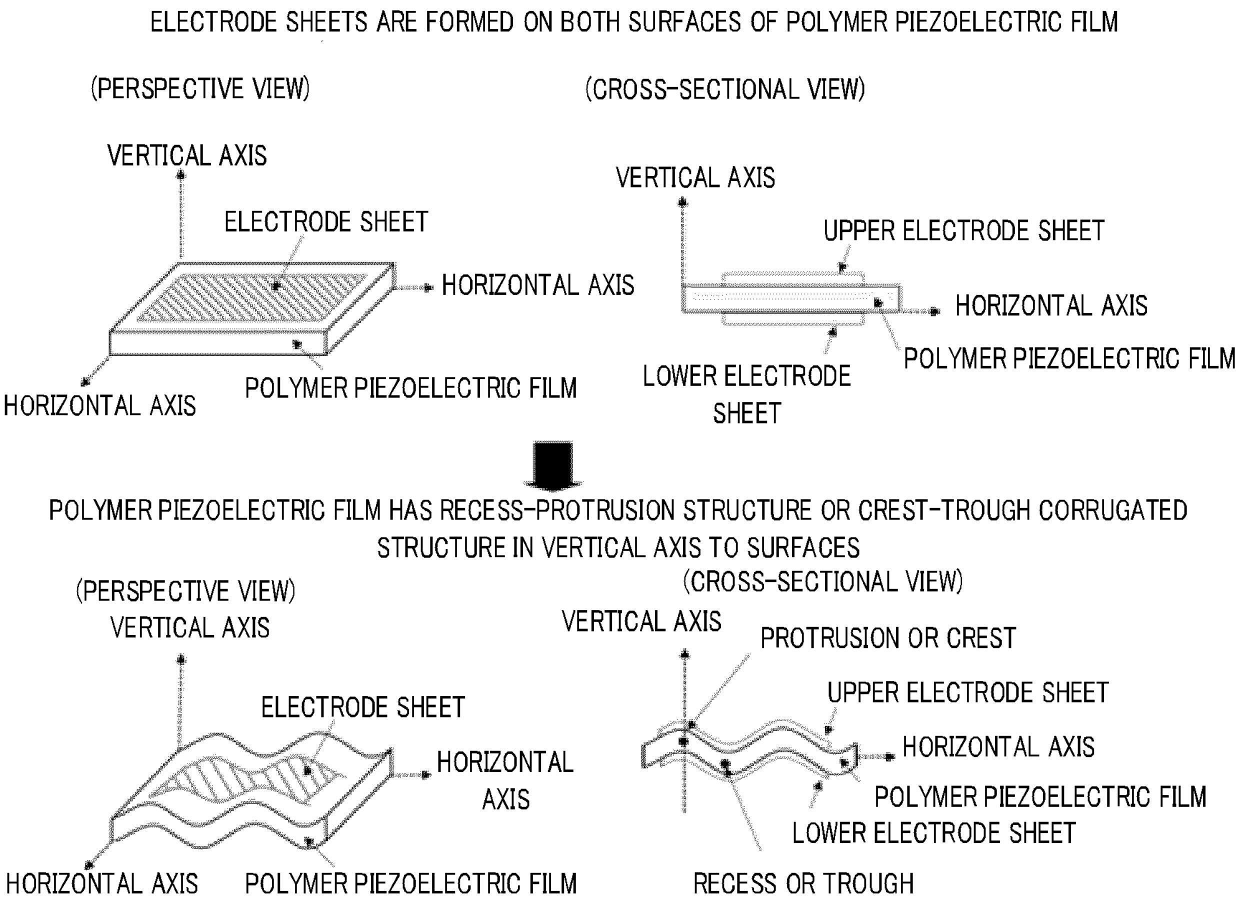
ELECTRODE SHEETS ARE FORMED ON BOTH SURFACES OF POLYMER PIEZOELECTRIC FILM
(PERSPECTIVE VIEW)
(CROSS-SECTIONAL VIEW)
VERTICAL AXIS
ELECTRODE SHEET
HORIZONTAL AXIS
HORIZONTAL AXIS
POLYMER PIEZOELECTRIC FILM
VERTICAL AXIS
UPPER ELECTRODE SHEET
HORIZONTAL AXIS
POLYMER PIEZOELECTRIC FILM
LOWER ELECTRODE SHEET
POLYMER PIEZOELECTRIC FILM HAS RECESS-PROTRUSION STRUCTURE OR CREST-TROUGH CORRUGATED STRUCTURE IN VERTICAL AXIS TO SURFACES
(PERSPECTIVE VIEW)
VERTICAL AXIS
ELECTRODE SHEET
HORIZONTAL AXIS
HORIZONTAL AXIS
POLYMER PIEZOELECTRIC FILM
(CROSS-SECTIONAL VIEW)
VERTICAL AXIS
PROTRUSION OR CREST
UPPER ELECTRODE SHEET
HORIZONTAL AXIS
POLYMER PIEZOELECTRIC FILM
LOWER ELECTRODE SHEET
RECESS OR TROUGH

FIG. 1

CASE WHERE RECESS-PROTRUSION STRUCTURE OR CREST-TROUGH CORRUGATED STRUCTURE IS FORMED AND MAINTAINED BY PLACING WIRES ON ONE ELECTRODE SHEET

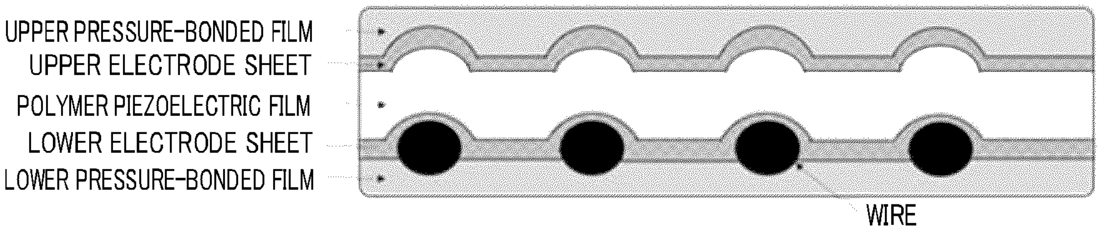


CASE WHERE RECESS-PROTRUSION STRUCTURE OR CREST-TROUGH CORRUGATED STRUCTURE IS FORMED AND MAINTAINED BY PLACING WIRES ON BOTH ELECTRODE SHEETS

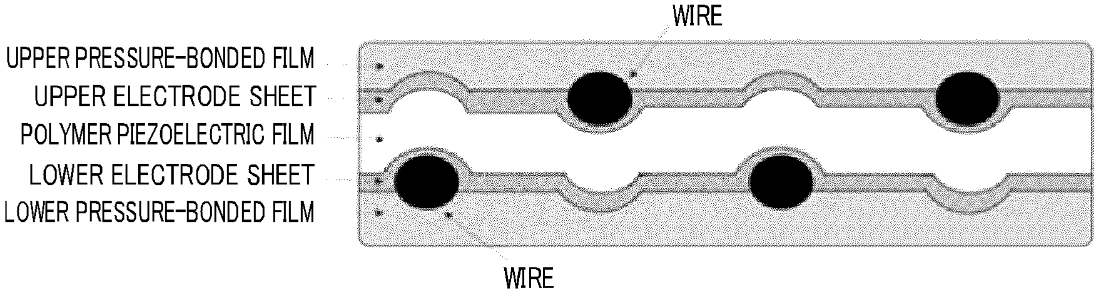


FIG. 2

CASE WHERE RECESS-PROTRUSION STRUCTURE OR CREST-TROUGH CORRUGATED STRUCTURE IS FORMED AND MAINTAINED BY PLACING WIRES BETWEEN ONE ELECTRODE SHEET AND POLYMER PIEZOELECTRIC FILM

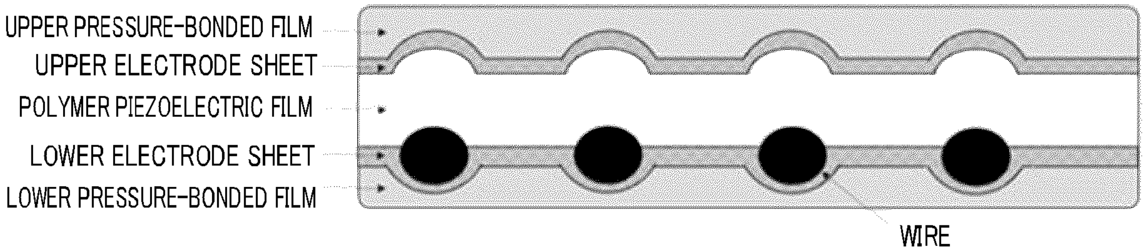


CASE WHERE RECESS-PROTRUSION STRUCTURE OR CREST-TROUGH CORRUGATED STRUCTURE IS FORMED AND MAINTAINED BY PLACING WIRES BETWEEN BOTH ELECTRODE SHEETS AND POLYMER PIEZOELECTRIC FILM

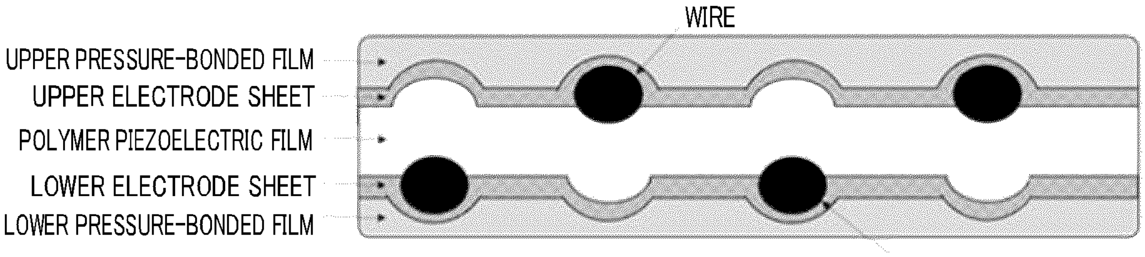


FIG. 3

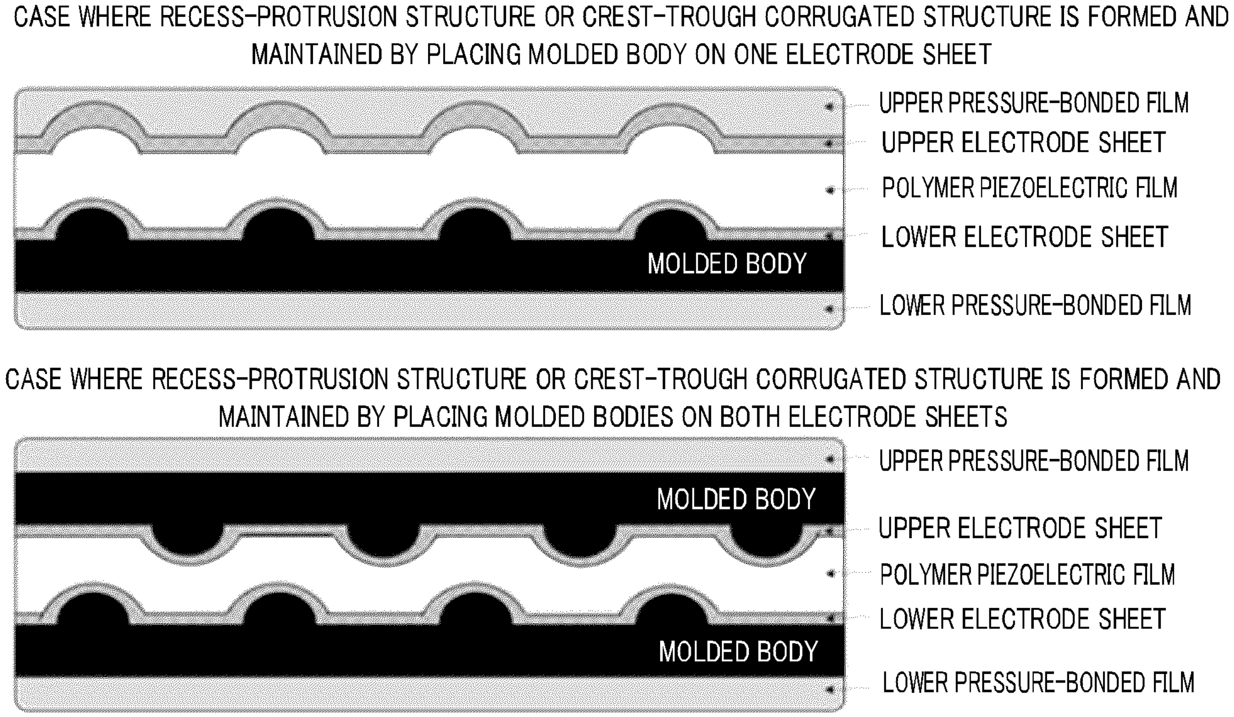
CASE WHERE RECESS-PROTRUSION STRUCTURE OR CREST-TROUGH CORRUGATED STRUCTURE IS FORMED AND MAINTAINED BY PLACING MOLDED BODY ON ONE ELECTRODE SHEET
UPPER PRESSURE-BONDED FILM
UPPER ELECTRODE SHEET
POLYMER PIEZOELECTRIC FILM
LOWER ELECTRODE SHEET
MOLDED BODY
LOWER PRESSURE-BONDED FILM
CASE WHERE RECESS-PROTRUSION STRUCTURE OR CREST-TROUGH CORRUGATED STRUCTURE IS FORMED AND MAINTAINED BY PLACING MOLDED BODIES ON BOTH ELECTRODE SHEETS
UPPER PRESSURE-BONDED FILM
MOLDED BODY
UPPER ELECTRODE SHEET
POLYMER PIEZOELECTRIC FILM
LOWER ELECTRODE SHEET
MOLDED BODY
LOWER PRESSURE-BONDED FILM

FIG. 4

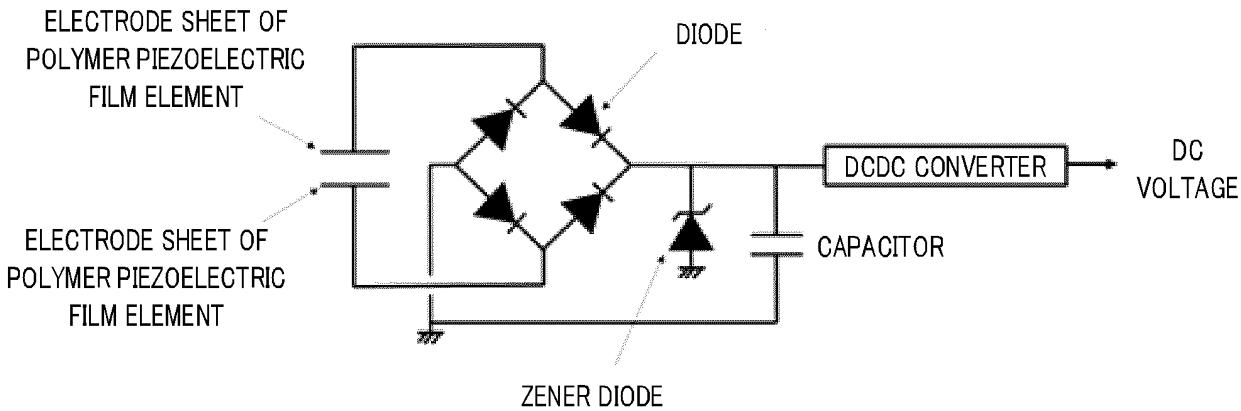
ELECTRODE SHEET OF POLYMER PIEZOELECTRIC FILM ELEMENT
DIODE
DCDC CONVERTER
DC VOLTAGE
CAPACITOR
ELECTRODE SHEET OF POLYMER PIEZOELECTRIC FILM ELEMENT
ZENER DIODE

FIG. 5

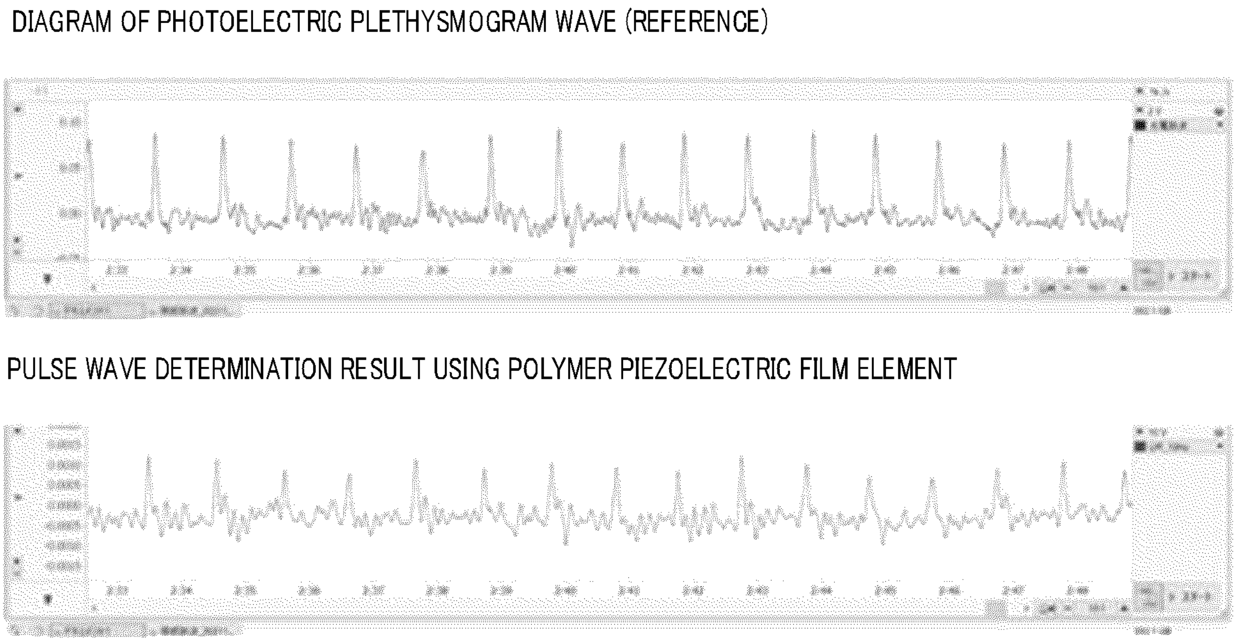
DIAGRAM OF PHOTOELECTRIC PLETHYSMOGRAM WAVE (REFERENCE)
PULSE WAVE DETERMINATION RESULT USING POLYMER PIEZOELECTRIC FILM ELEMENT

FIG. 6

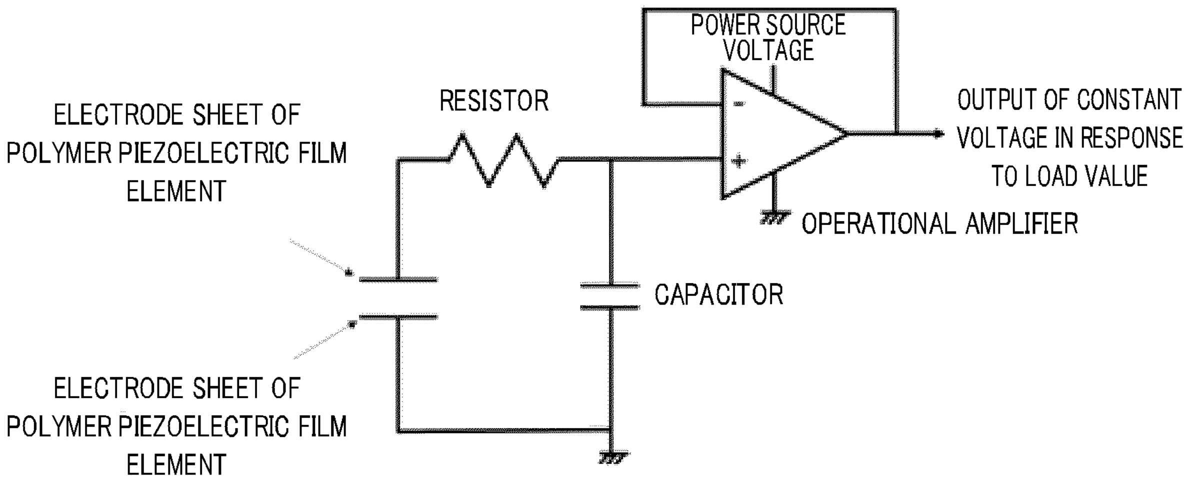
POWER SOURCE VOLTAGE
ELECTRODE SHEET OF POLYMER PIEZOELECTRIC FILM ELEMENT
RESISTOR
OUTPUT OF CONSTANT VOLTAGE IN RESPONSE TO LOAD VALUE
OPERATIONAL AMPLIFIER
CAPACITOR
ELECTRODE SHEET OF POLYMER PIEZOELECTRIC FILM ELEMENT

FIG. 7

VERTICAL AXIS: VOLTAGE (V)

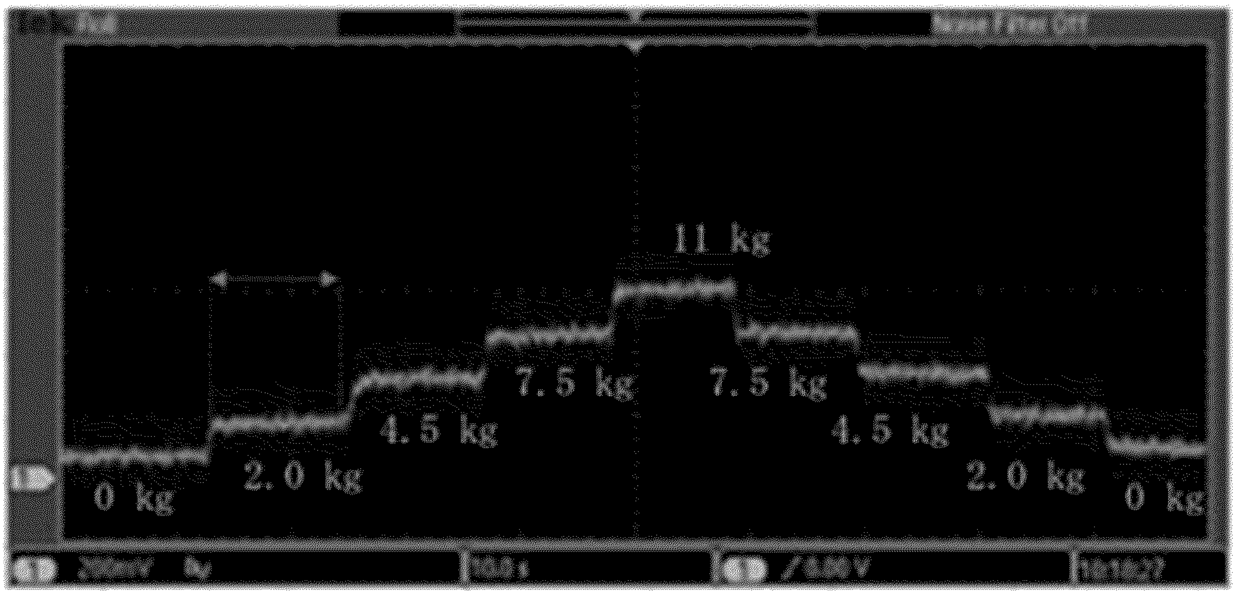


HORIZONRAL AXIS: TIME (s)

FIG. 8

**INTERNATIONAL SEARCH REPORT**

International application No. **PCT/JP2022/018032**

**A. CLASSIFICATION OF SUBJECT MATTER**

***H01L 41/193***(2006.01)i; ***H01L 41/113***(2006.01)i; ***H01L 41/257***(2013.01)i; ***H02N 2/18***(2006.01)i
FI: H01L41/193; H02N2/18; H01L41/113; H01L41/257

According to International Patent Classification (IPC) or to both national classification and IPC

**B. FIELDS SEARCHED**

Minimum documentation searched (classification system followed by classification symbols)

H01L41/193; H01L41/113; H01L41/257; H02N2/18

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | WO 2020/261954 A1 (FUJIFILM CORP.) 30 December 2020 (2020-12-30) paragraphs [0017], [0028], [0043], [0047], [0079], [0151], fig. 1-9 | 1, 6, 7 |
| Y | | 3-5, 10, 11 |
| A | | 2, 8, 9 |
| X | WO 2009/107305 A1 (TAKEI, Toshitaka) 03 September 2009 (2009-09-03) paragraphs [0040], [0042], fig. 1-23 | 1, 7 |
| Y | | 3-5 |
| A | | 2, 6, 8-11 |
| Y | JP 2011-222679 A (DAIKIN INDUSTRIES, LTD.) 04 November 2011 (2011-11-04) paragraph [0038], fig. 1-5 | 3, 4 |
| Y | WO 2018/181261 A1 (TOHO KASEI CO., LTD.) 04 October 2018 (2018-10-04) paragraph [0030], fig. 1-6 | 5 |
| Y | JP 2017-17831 A (TEIJIN LTD.) 19 January 2017 (2017-01-19) paragraphs [0021], [0035], fig. 1-7 | 10 |

☑ Further documents are listed in the continuation of Box C. ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **06 July 2022** | **19 July 2022** |
| Name and mailing address of the ISA/JP<br>**Japan Patent Office (ISA/JP)**<br>**3-4-3 Kasumigaseki, Chiyoda-ku, Tokyo 100-8915**<br>**Japan** | Authorized officer<br><br>Telephone No. |

Form PCT/ISA/210 (second sheet) (January 2015)

**INTERNATIONAL SEARCH REPORT**

International application No.
**PCT/JP2022/018032**

**C. DOCUMENTS CONSIDERED TO BE RELEVANT**

| Category* | Citation of document, with indication, where appropriate, of the relevant passages | Relevant to claim No. |
|---|---|---|
| Y | WO 2012/137897 A1 (MURATA MANUFACTURING CO., LTD.) 11 October 2012 (2012-10-11)<br>paragraphs [0067], [0085], [0087], fig. 1-26 | 11 |

Form PCT/ISA/210 (second sheet) (January 2015)

**INTERNATIONAL SEARCH REPORT**
**Information on patent family members**

International application No.
**PCT/JP2022/018032**

| Patent document cited in search report | Publication date (day/month/year) | Patent family member(s) | Publication date (day/month/year) |
|---|---|---|---|
| WO 2020/261954 A1 | 30 December 2020 | (Family: none) | |
| WO 2009/107305 A1 | 03 September 2009 | (Family: none) | |
| JP 2011-222679 A | 04 November 2011 | (Family: none) | |
| WO 2018/181261 A1 | 04 October 2018 | (Family: none) | |
| JP 2017-17831 A | 19 January 2017 | (Family: none) | |
| WO 2012/137897 A1 | 11 October 2012 | US 2014/0049137 A1<br>paragraphs [0093], [0111], [0113], fig. 1-26<br>EP 2696163 A1 | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 2020230509 A
- WO 2020235208 A
- JP 2020061938 A
- JP 2020119995 A
- JP 2014111911 A
- JP 2021076711 A


### Non-patent literature cited in the description


- **H. KAWAI.** *Jpn. J. Appl. Phys.,* 1969, vol. 8, 975
- Field Responsive Polymers. 88-103
- **KENJI UCHINO.** Ferroelectric Devices. Morikita Publishing Co., Ltd, 142